# EUROPEAN PATENT SPECIFICATION

(11) **EP 0 590 712 B1**
(45) Date of publication and mention of the grant of the patent: **20.08.1997**
(21) Application number: 93202716.2
(22) Date of filing: 20.09.1993
(51) Int. Cl.: G01R 33/36, G01R 33/58

(54) **Magnetic resonance apparatus**
Kernspinresonanzgerät
Appareil à résonance magnétique

(30) Priority: 29.09.1992 EP 92202975
(43) Date of publication of application: 06.04.1994
(73) Proprietor: Philips Electronics N.V., 5621 BA Eindhoven (NL)
(72) Inventor: Rust, Johan Willem, Int. Octrooibureau B.V., NL-5656 AA Eindhoven (NL); Van Heelsbergen, T. R., Int. Octrooibureau B.V., NL-5656 AA Eindhoven (NL)
(74) Representative: Bakker, Hendrik

(56) References cited:
- US-A- 4 717 881
- US-A- 4 719 406
- US-A- 4 731 585
- US-A- 5 051 700
- MEDICAL PHYSICS. vol. 11, no. 2 , 1 March 1984 , NEW YORK US pages 180 - 185 W.A. EDELSTEIN ET AL. 'A SIGNAL-TO-NOISE CALIBRATION PROCEDURE FOR NMR IMAGING SYSTEMS'
- THE BRITISH JOURNAL OF RADIOLOGY vol. 59, no. 706 , 1 October 1986 , LONDON, GB pages 1031 - 1034 S.J. JENNINGS ET AL. 'SIMULATION OF PATIENT LOADING IN NUCLEAR MAGNETIC RESONANCE IMAGING THROUGH THE USE OF INDUCTIVE DAMPING LOOPS'
- MAGNETIC RESONANCE IN MEDICINE. vol. 16, no. 2 , 1 November 1990 , DULUTH,MN US pages 294 - 302 T.J. LAWRY ET AL. 'COMPUTER MODELING OF SURFACE COIL SENSITIVITY'

## Description

The invention relates to a magnetic resonance apparatus, comprising a magnet system for generating a steady magnetic field, a coil system for generating gradient fields, and at least one RF coil which comprises a circuit with at least a self-inductance and a tuning capacitor, which circuit is tuned to a predetermined frequency and connected to first and second input terminals of an input amplifier of a receiving device for RF signals.

An apparatus (MR apparatus) of this kind is known from, for example US-A-4 737 718. Apparatus of this kind are customarily delivered together with a set of phantoms which can be used to check the imaging quality of the RF coils and the entire MR chain. The phantoms serve to simulate the presence of an object to be examined, for example a patient. They are used during installation of the apparatus, during fault-finding in the MR chain, during adjustment of the RF coils and the MR chain, and during image quality tests to be performed at regular intervals. A phantom usually consists of two segments, that is to say on the one hand a segment containing elements which can be imaged by the MR apparatus and which can serve to measure parameters which are decisive in respect of the image quality (for example, signal-to-noise ratio and uniformity), and on the other hand a segment which simulates the loading of the RF coil by the patient. This is because said parameters are co-determined by the coil quality Q arising from the RF coil itself and the coil load caused by the patient. Thus far, the load segment is customarily constructed as an annular vessel which is filled with an electrically conductive liquid (for example a saline solution) or as a closed circuit which can be inductively coupled to the RF coil and which may comprise, for example a coil, a resistor and a capacitor. Examples of such load phantoms are described in The British Journal of Radiology, 59, pp. 1031-1034. Generally speaking, a separate load phantom is required for each RF coil associated with the MR apparatus. The known phantoms of the described constructions are often comparatively voluminous, complex and difficult to handle. Moreover, they may be vulnerable and expensive.

It is an object of the invention to provide a magnetic resonance apparatus which does not require the supply of load phantoms for the various RF coils. To achieve this, the apparatus in accordance with the invention is characterized in that the circuit formed by the RF coil and the input amplifier circuit includes a load network which comprises at least a switch and a resistor which can be coupled to the RF coil by means of said switch.

In an apparatus of this kind, the loading by the patient can be very simply simulated by closing the switch so that the resistor is connected parallel to the input of the input amplifier. The load network may form part of the RF coil so that when a new RF coil is fitted, the associated load network is automatically present. Thus, it is no longer necessary to supply voluminous and expensive load phantoms with the RF coils and the mounting of such phantoms in the coils can also be dispensed with. Therefore, such mounting can no longer be forgotten and, moreover, positioning errors can no longer occur during mounting.

A first embodiment of the apparatus in accordance with the invention is characterized in that the first and second input terminals of the input amplifier circuit are interconnected *via* the load network, the load network comprising at least a first series connection of a first switch and a first resistor. The first switch is preferably formed by a first diode, one electrode of which is connected to one of the input terminals of the input amplifier circuit, its other electrode being connected to an end of the first resistor whose other end is connected to the other input terminal *via* a first capacitor, the junction point of the first resistor and the first capacitor also being connected to a control terminal whereto a positive or a negative direct voltage, relative to the first input terminal, can be applied as desired. The load network can thus be switched on or off by choosing the control voltage to be applied to the control terminal. The diode is preferably a so-called PIN diode as customarily used for switching on and off elements of RF coils in MR apparatus.

A further embodiment is characterized in that the load network also comprises a second series connection of a second switch and a second resistor, which series connection is connected, at least for RF signals, parallel to the first series connection. In this embodiment, both resistors can be simultaneously switched on or off by choosing the control voltage.

In many cases an object to be measured which is coupled to the RF coil not only causes a reduction of the coil quality, as can be simulated by the above first and second resistors, but also a frequency shift. This frequency shift can be simulated in a further embodiment which is characterized in that an impedance of a capacitive or inductive nature is connected parallel to at least one of the first and second resistors.

A second embodiment of the apparatus in accordance with the invention is characterized in that the load network comprises a parallel connection of a switch and a resistor, which parallel connection is included in the circuit forming the RF coil.

These and other aspects of the invention will be described in detail hereinafter with reference to the drawing.

Fig. 1 shows diagrammatically an embodiment of a magnetic resonance apparatus in accordance with the invention.

Fig. 2 shows an electric circuit diagram of a part of a first embodiment of the apparatus shown in Fig. 1, and

Fig. 3 shows an electric circuit diagram of a part of a second embodiment of the apparatus shown in Fig. 1.

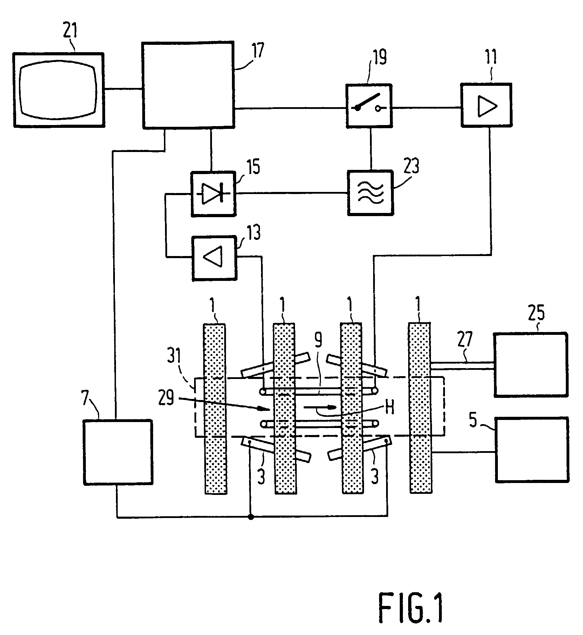

The magnetic resonance apparatus which is diagrammatically shown in Fig. 1 comprises a first magnet system 1 for generating a steady magnetic field H, a second magnet system 3 for generating magnetic gradient fields, and first and second power supply sources 5 and 7 for the first magnet system 1 and the second magnet system 3, respectively. An RF coil 9 serves to generate an RF magnetic alternating field; to this end, it is connected to an RF source 11. For detection of nuclear spin resonance signals generated by the RF transmitted field in an object to be examined (not shown), use can also be made of the RF coil 9; to this end, this coil is connected to a receiving device 13 for RF signals. The output of the receiving device 13 is connected to a detector circuit 15 which is connected to a central control device 17. The central control device 17 also controls a modulator 19 for the RF source 11, the second power supply source 7, and a monitor 21 for image display. An RF oscillator 23 controls the modulator 19 as well as the detector 15 processing the measurement signals. For cooling, if any, of the magnet coils of the first magnet system 1 there is provided a cooling device 25 comprising cooling ducts 27. A cooling device of this kind may be constructed as a water-cooling system for resistive coils or, as for the high field strengths required in the present case, for example, as a liquid-helium cooling system for superconducting magnet coils. The RF coil 9, arranged within the magnet systems 1 and 3, encloses a measurement space 29 which is large enough to accommodate the patient to be examined, or a part of the patient to be examined, for example the head and the neck, in an apparatus for medical diagnostic measurements. Thus, in the measurement space 29 there can be generated a steady magnetic field H, gradient fields for selecting object slices, and a spatially uniform RF alternating field. The RF coil 9 can combine the functions of transmitter coil and measuring coil. Alternatively, different coils can be used for the two functions; for example, the measuring coils can be constructed as surface coils or butterfly coils, see US-A-4 816 765 or as bird cage coils, see US-A-4 737 718. Hereinafter, the RF coil 9 will be referred to only as a measuring coil. If desired, the coil 9 may be enclosed by a Faraday cage 31 shielding RF fields.

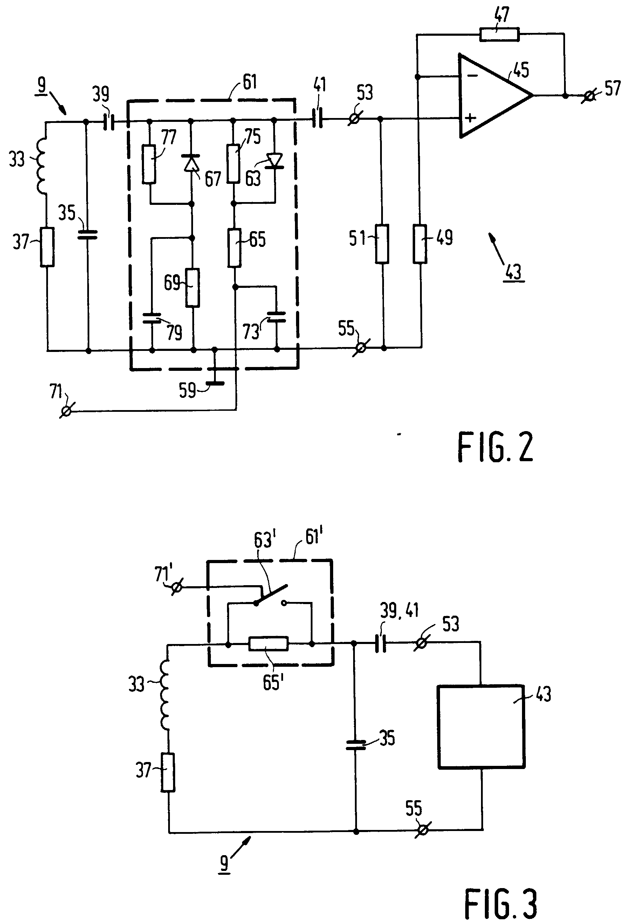

Fig. 2 shows a circuit diagram of the RF coil 9 and a part of the receiving device 13. As is customary, the RF coil 9 comprises a circuit, tuned to a predetermined frequency, with a pure self-inductance 33, a tuning capacitor 35 and a loss resistor 37. *Via* two series-connected coupling capacitors 39 and 41, the RF coil 9 is connected to an input amplifier circuit 43 of the receiving device 13. In the present embodiment, the input amplifier circuit 43 comprises an operational amplifier 45 which is set by means of (very high-ohmic) resistors 47, 49 and 51. The input amplifier circuit 43 may also comprise other elements which are known *per se*, for example a network of coils and capacitors. It comprises first and second input terminals 53 and 55 and an output terminal 57. The first input terminal 53 is connected, *via* the two coupling capacitors 39 and 41, to a first end of the RF coil 9, and the second input terminal 55 is connected to the other end of the RF coil and to a reference point 59 of fixed potential. The output terminal 57 is connected to further parts of the receiving device 13 or directly to the detector 15.

Between the junction point of the two coupling capacitors 39 and 41 on the one side and the reference point 59 on the other side there is connected a load network 61 which thus constitutes a connection between the first and the second input terminals 53 and 55 of the input amplifier 43. The load network 61 comprises a first series connection of a first switch 63 and a first resistor 65, and also a second series connection of a second switch 67 and a second resistor 69. In the present embodiment, the first and the second switches 63 and 67 are formed by first and second diodes, preferably PIN diodes. The anode of the first diode 63 and the cathode of the second diode 67 are connected (*via* the coupling capacitor 41) to the first input terminal 53, the other electrodes of these diodes being connected to one end of the first resistor 65 and the second resistor 69, respectively. The other end of the first resistor 65 is connected to a control terminal 71 and to an electrode of a capacitor 73, the other electrode of which is connected to the reference point 59. The other end of the second resistor 69 is connected directly to the reference point 59. A positive or negative direct voltage, relative to the reference point 59, can be applied, as desired, to the control terminal 71 *via* switching means (not shown). If the applied direct voltage (referred to hereinafter as control voltage) is positive, for example +300 V, both diodes 63, 65 are blocked so that the load network 61 has no effect on the quality Q of the RF coil 9. This is the state which occurs when the apparatus is used for a normal measurement. During the testing of the apparatus, for example upon installation or after replacement of coils and other parts of the MR chain, a negative control voltage of, for example -10 V is applied, so that both diodes 63, 67 become conductive. The diodes thus act as switches which, in the conductive state, connect one end of the first and the second resistors 65, 69, to the first input terminal 53 and hence also to the RF coil 9. The other end of the first resistor 65 is connected, *via* the capacitor 73, to the second input terminal 55 whereas the other end of the second resistor 69 is connected directly to the second input terminal, so that for RF signals these two resistors are connected in parallel and interconnect the two input terminals. They thus constitute a load resistance for the RF coil 9 which simulates a coil load caused by a patient. For direct voltages, the first resistor 65, the two diodes 63, 67 and the second resistor 69 are connected in series between the control terminal 71 and the reference point 59. In order to distribute the reverse voltage uniformly between the two diodes 63, 67 in the case of a positive control voltage, a resistor 75, 77 is connected parallel to each of these diodes. The values of these resistors are preferably equal and very high.

If desired, like in the embodiment shown, a frequency shift caused by the presence of the patient can also be simulated by connecting an impedance 79 parallel to the second resistor 69. In the present example the impedance 79 simply consists of a capacitor, so that the impedance is of a capacitive nature. A shift to a lower frequency is thus simulated, which shift has been found to occur most frequently in practice. A frequency shift to higher values could be simulated by an impedance 79 of an inductive nature, for example by replacing the capacitor by a coil.

Various alternative versions are feasible for the described embodiment. For example, it may suffice to use only one series connection of a switch and a resistor. To this end, for example the second series connection (of the second diode 67 and the second resistor 69) may be omitted, the anode of the first diode then being connected, *via* a high-ohmic resistor, to the reference point 59 in order to realise a closed circuit for the control signal to be applied *via* the control terminal 71. It is alternatively possible to connect the first diode 63 between an end of the first resistor 65 and the second input terminal 55 and to apply the control voltage *via* the other end of said resistor. Said other end should then be connected, *via* a capacitor such as the capacitor 73, to the first input terminal 53 in order to ensure that for RF signals the resistor can be connected parallel to the input of the amplifier 43. The switches 63 and 67 may also be formed by other, known switching elements, for example transistors, instead of PIN diodes. If desired, the first and second resistors 65, 69 and the impedance 79 may be constructed so as to be variable. The load circuit 69 can be combined with the RF coil 9 so as to form one structural unit.

If desired, the control voltage can be applied *via* a high self-inductance or *via* an RF rejection filter, comprising a parallel connection of a self-inductance and a capacitor. In that case complete isolation for RF signals exists between the control voltage source and the load network 61.

Fig. 3 shows an embodiment in which the load network 61' comprises a parallel connection of a switch 63' and a resistor 65'. This parallel connection is included in the circuit forming the RF coil 9. The switch 61' can be opened or closed by applying a suitable control voltage to the control terminal 71'. When the switch is open, the resistor 65' is connected in series with the loss resistor 37 and, when the switch is closed, the resistor is short-circuited. Thus, like in the first embodiment, the resistor 65' can be coupled to the RF coil 9 by means of the switch 63'. Various embodiments are feasible for the switch 63' and the resistor 65', analogous to the description given with reference to Fig. 2.

## Claims

1. A magnetic resonance apparatus, comprising a magnet system (1) for generating a steady magnetic field, a coil system (3) for generating gradient fields, and at least one RF coil (9) which comprises a circuit with at least a self-inductance (33) and a tuning capacitor (35), which circuit is tuned to a predetermined frequency and connected to first and second input terminals (53, 55) of an input amplifier circuit (43) of a receiving device (13) for RF signals, characterized in that the circuit formed by the RF coil (9) and the input amplifier circuit (43) includes a load network (61, 61') which comprises at least a switch (63, 67; 63') and a resistor (65, 69; 65') which can be coupled to the RF coil by means of said switch.

2. A magnetic resonance apparatus as claimed in Claim 1, characterized in that the first and second input terminals (53, 55) of the input amplifier circuit (43) are interconnected *via* the load network (61), the load network comprising at least a first series connection of a first switch (63) and a first resistor (65).

3. A magnetic resonance apparatus as claimed in Claim 2, characterized in that the first switch is formed by a first diode (63), one electrode of which is connected to one of the input terminals (53) of the input amplifier circuit (43), its other electrode being connected to one end of the first resistor (65), whose other end is connected to the other input terminal (55) *via* a first capacitor (73), the junction point of the first resistor and the first capacitor also being connected to a control terminal (71) whereto a positive or a negative direct voltage, relative to the first input terminal (53), can be applied as desired.

4. A magnetic resonance apparatus as claimed in Claim 2 or 3, characterized in that the load network (61) also comprises a second series connection of a second switch (67) and a second resistor (69), which series connection is connected, at least for RF signals, parallel to the first series connection (63, 65).

5. A magnetic resonance apparatus as claimed in Claim 4, characterized in that the anode of the first diode (63) and the cathode of the second diode (65) are connected to the first input terminal (53) of the input amplifier circuit (43).

6. A magnetic resonance apparatus as claimed in any one of the preceding Claims, characterized in that an impedance (79) of a capacitive or inductive nature is connected parallel to at least one of the first and second resistors (65, 69).

7. A magnetic resonance apparatus as claimed in Claim 1, characterized in that the load network (61') comprises a parallel connection of a switch (63') and a resistor (65'), which parallel connection is included in the circuit forming the RF coil (9).

## Patentansprüche

1. Kernspinresonanzgerät mit einem Magnetsystem (1) zum Generieren eines stationären Magnetfeldes, einem Spulensystem (3) zum Generieren von Gradientenfeldern und zumindest einer HF-Spule (9), die einen Kreis mit zumindest einer Selbstinduktivität (33) und einem Abstimmkondensator (35) umfaßt, welcher Kreis auf eine vorgegebene Frequenz abgestimmt ist und mit ersten und zweiten Eingangsklemmen (53, 55) einer Eingangsverstärkerschaltung (43) einer Empfangseinrichtung (13) für HF-Signale verbunden ist, dadurch gekennzeichnet, daß der von der HF-Spule (9) und der Eingangsverstärkerschaltung (43) gebildete Schaltkreis ein Lastnetz (61, 61') enthält, das zumindest einen Schalter (63, 67; 63') und einen Widerstand (65, 69; 65'), der mit Hilfe des genannten Schalters mit der HF-Spule gekoppelt werden kann, umfaßt.

2. Kernspinresonanzgerät nach Anspruch 1, dadurch gekennzeichnet, daß die ersten und zweiten Eingangsklemmen (53, 55) der Eingangsverstärkerschaltung (43) über das Lastnetz (61) miteinander verbunden sind, wobei das Lastnetz zumindest eine erste Reihenschaltung aus einem ersten Schalter (63) und einem ersten Widerstand (65) umfaßt.

3. Kernspinresonanzgerät nach Anspruch 2, dadurch gekennzeichnet, daß der erste Schalter von einer ersten Diode (63) gebildet wird, von der eine Elektrode mit einer der Eingangsklemmen (53) der Eingangsverstärkerschaltung (43) verbunden ist, wobei ihre andere Elektrode mit einem Ende des ersten Widerstandes (65) verbunden ist, dessen anderes Ende über einen ersten Kondensator (73) mit der anderen Eingangsklemme (55) verbunden ist, wobei der Verbindungspunkt des ersten Widerstandes und des ersten Kondensators auch mit einer Steuerklemme (71) verbunden ist, an der wahlweise eine relativ zur ersten Eingangsklemme (53) positive oder negative Gleichspannung angelegt werden kann.

4. Kernspinresonanzgerät nach Anspruch 2 oder 3, dadurch gekennzeichnet, daß das Lastnetz (61) auch eine zweite Reihenschaltung aus einem zweiten Schalter (67) und einem zweiten Widerstand (69) umfaßt, die zumindest für HF-Signale parallel zur ersten Reihenschaltung (63, 65) geschaltet ist.

5. Kernspinresonanzgerät nach Anspruch 4, dadurch gekennzeichnet, daß die Anode der ersten Diode (63) und die Kathode der zweiten Diode (65) mit der ersten Eingangsklemme (53) der Eingangsverstärkerschaltung (43) verbunden sind.

6. Kernspinresonanzgerät nach einem der vorhergehenden Ansprüche, dadurch gekennzeichnet, daß eine Impedanz (79) kapazitiver oder induktiver Art zumindest zu einem der ersten und zweiten Widerstände (65, 69) parallel geschaltet ist.

7. Kernspinresonanzgerät nach Anspruch 1, dadurch gekennzeichnet, daß das Lastnetz (61') eine Parallelschaltung aus einem Schalter (63') und einem Widerstand (65') umfaßt, welche Parallelschaltung in dem die HF-Spule (9) bildenden Kreis enthalten ist.

## Revendications

1. Appareil à résonance magnétique comportant un système magnétique (1) pour engendrer un champ magnétique stationnaire, un système de bobines (3) servant à engendrer des champs de gradient, et au moins une bobine RF (9) comprenant un circuit présentant au moins une auto-inductance (33) et un condensateur d'accord (35), lequel circuit est accordé à une fréquence prédéterminée et connecté à des première et deuxième bornes d'entrée (53, 55) d'un circuit amplificateur d'entrée (43) d'un dispositif récepteur (13) pour des signaux RF, caractérisé en ce que le circuit formé par la bobine RF (9) et le circuit amplificateur d'entrée (43) comporte un réseau de charge (61, 61a) comprenant au moins un commutateur (63, 67; 63') et une résistance (65, 69; 6'), qui peut être couplée à la bobine RF à l'aide dudit commutateur.

2. Appareil à résonance magnétique selon la revendication 1, caractérisé en ce que les première et deuxième bornes d'entrée (53, 55) du circuit amplificateur d'entrée (63) sont interconnectées par l'intermédiaire du réseau de charge (61), le réseau de charge comprenant au moins un premier montage en série d'un premier commutateur (63) et d'une première résistance (65).

3. Appareil à résonance magnétique selon la revendication 2, caractérisé en ce que le premier commutateur est formé par une première diode (63), dont une électrode est connectée à l'une des bornes d'entrée (53) du circuit amplificateur d'entrée (43), son autre électrode étant connectée à une extrémité de la première résistance (65), dont l'autre extrémité est connectée à l'autre borne d'entrée (55) par l'intermédiaire d'un premier condensateur (73), le point de jonction de la première résistance et du premier condensateur étant également connecté à une borne de commande (71) à laquelle peut être appliquée au choix une tension continue positive ou négative par rapport à la première borne d'entrée (53).

4. Appareil à résonance magnétique selon la revendication 2 ou 3, caractérisé en ce que le réseau de charge (61) est également muni d'un deuxième montage en série d'un deuxième commutateur (67) et d'une deuxième résistance (69), lequel montage en série est connecté, au moins pour les signaux RF, en parallèle au premier montage en série (63, 65).
dispositif.

5. Appareil à résonance magnétique selon la revendication 4, caractérisé en ce que l'anode de la première diode (63) et la cathode de la deuxième diode (65) sont connectées à la première borne d'entrée (53) du circuit amplificateur d'entrée (43).

6. Appareil à résonance magnétique selon l'une des revendications précédentes, caractérisé en ce qu'une impédance (79) d'un caractère capacitif ou inductif est montée en parallèle à au moins l'une des première et deuxième résistances (65, 69).

7. Appareil à résonance magnétique selon la revendication 1, caractérisé en ce que le réseau de charge (61') comprend un montage en parallèle d'un commutateur (63') et d'une résistance (65'), lequel montage en parallèle est logé dans le circuit formant la bobine RF (9).
